# EUROPEAN PATENT APPLICATION

(11) **EP 4 481 795 A1**
(43) Date of publication of application: **25.12.2024**
(21) Application number: 22927328.9
(22) Date of filing: 13.12.2022
(51) Int. Cl.: H01L 21/3065

(54) **ETCHING METHOD**

(30) Priority: 16.02.2022 JP 2022022024
(71) Applicant: Resonac Corporation, Tokyo 105-7325 (JP)
(72) Inventor: SUZUKI Atsushi, Tokyo 105-8518 (JP)
(74) Representative: Strehl Schübel-Hopf & Partner
(86) International application number: PCT/JP2022/045919
(87) International publication number: WO 2023/157442

(57) **Abstract**

There is provided a low-temperature etching method that hardly causes the bowing and the etch stop. The etching method has an etching step of setting the temperature of a member to be etched (4) having an etching object containing silicon to 0°C or less, bringing an etching gas containing an etching compound into contact with the member to be etched (4), and etching the etching object. The etching gas contains or does not contain high-boiling-point impurities, the high-boiling-point impurities being compounds having at least one type of atom among a fluorine atom, a chlorine atom, a bromine atom, an iodine atom, a hydrogen atom, and an oxygen atom in the molecule and having a boiling point of 20°C or more under a pressure of 101 kPa, and, when the etching gas contains the high-boiling-point impurities, the total concentration of all types of the contained high-boiling-point impurities is 500 ppm by volume or less.

## Description

### Technical Field

The present invention relates to an etching method.

### Background Art

When manufacturing semiconductor elements, wiring lines are formed on a wafer by plasma etching. As the miniaturization of the wiring lines has progressed, a demand for wiring lines having a line width of 20 nm or less has increased. Therefore, when minute particles having a diameter of 100 nm or less are generated and remain on the wafer in plasma etching, there is a risk that the minute particles short-circuit the wiring lines or become obstacles in the subsequent etching, deposition steps, or the like, resulting in the inability to form the wiring lines. As a result, regions where designed electrical characteristics are not obtained are generated in the wafer, leading to a decrease in the productivity of the semiconductor elements. Accordingly, it is preferable that particles are hardly generated in the plasma etching. As a plasma etching method in which particles are hardly generated, a high-temperature etching method, in which etching is performed at temperatures equal to or more than normal temperature, is known.

In the plasma etching used in the manufacture of the semiconductor elements, a low side etching rate has been required. More specifically, in etching of an opening part having a high aspect ratio, it is preferable that lateral etching of a layer to be etched (e.g., a silicon-containing layer) directly under a mask hardly occurs. In the high-temperature etching method, particles are hardly generated. However, it has not been able to be said that the high-temperature etching method has had a sufficiently low side etching rate. As a plasma etching method having a low side etching rate, a low-temperature etching method in which etching is performed at temperatures of 0°C or less is known (see PTL 1, for example).

### Citation List

### Patent Literature

PTL 1: JP 2019-153771 A

### Summary of Invention

### Technical Problem

However, the low-temperature etching method has had a low side etching rate but has sometimes posed such problems that the etching rate is low and the etching selectivity is low. A detailed description is given below.

An etching gas has had a risk of mixing of impurities (e.g., impurities originating from an etching gas manufacturing step). The mixed impurities have had a risk of being condensed in etching, causing a decrease in the etching rate and the etching selectivity.

For example, the occurrence of the condensation of the impurities in a hole during etching for forming the hole blocks the flowing of the etching gas to a bottom part of the hole, which has posed a risk that an etch stop (a phenomenon in which the etching does not progress and stops) occurs, reducing the etching rate. Further, the occurrence of the condensation of the impurities in the hole during the etching for forming the hole has posed a risk that the condensed impurities become etchants and undesirable chemical etching progresses, and therefore bowing (a phenomenon in which the etching in a direction lateral to the etching direction progresses, so that the side walls are recessed) occurs, reducing the etching selectivity. In particular, high-boiling-point impurities are likely to condense in the low-temperature etching, and therefore have been likely to cause the above-described problems.

It is an object of the present invention to provide a low-temperature etching method that hardly causes the bowing and the etch stop.

### Solution to Problem

To achieve the above-described object, one aspect of the present invention is as described in [1] to [9] below.
[1] An etching method including: an etching step of setting the temperature of a member to be etched having an etching object containing silicon to 0°C or less, bringing an etching gas containing an etching compound into contact with the member to be etched, and etching the etching object, in which
   the etching gas contains or does not contain high-boiling-point impurities, the high-boiling-point impurities being compounds having at least one type of atom among a fluorine atom, a chlorine atom, a bromine atom, an iodine atom, a hydrogen atom, and an oxygen atom in the molecule and having a boiling point of 20°C or more under a pressure of 101 kPa, and, when the etching gas contains the high-boiling-point impurities, the total concentration of all types of the contained high-boiling-point impurities is 500 ppm by volume or less.
[2] The etching method according to [1], in which the total concentration of all types of the contained high-boiling-point impurities is 0.01 ppm by volume or more and 300 ppm by volume or less.
[3] The etching method according to [1] or [2], in which the high-boiling-point impurity is at least one type among water, hydrogen fluoride, ethanol, isopropanol, chloroform, dichloromethane, cyclohexane, benzene, iodine molecules, and bromine molecules.
[4] The etching method according to any one of [1] to [3], in which the etching compound is a compound having at least one type of atom among a fluorine atom, a chlorine atom, a bromine atom, an iodine atom, and a hydrogen atom in the molecule and having a boiling point of 15°C or less under a pressure of 101 kPa.
[5] The etching method according to [4], in which the etching compound is the compound having a fluorine atom in the molecule and is at least one type among sulfur hexafluoride, nitrogen trifluoride, chlorine trifluoride, iodine heptafluoride, phosphorus trifluoride, silicon tetrafluoride, fluorine gas, trifluoroiodomethane, carbonyl fluoride, trifluoromethyl hypofluoride, chain saturated perfluorocarbons having 1 or more and 3 or less carbon atoms, chain saturated hydrofluorocarbons having 1 or more and 3 or less carbon atoms, unsaturated perfluorocarbons having 2 or more and 5 or less carbon atoms, unsaturated hydrofluorocarbons having 2 or more and 4 or less carbon atoms, cyclic perfluorocarbons having 3 or more and 5 or less carbon atoms, and cyclic hydrofluorocarbons having 3 or more and 5 or less carbon atoms.
[6] The etching method according to [4], in which the etching compound is the compound having a chlorine atom in the molecule and is at least one type among boron trichloride, chlorine gas, hydrogen chloride, chlorine trifluoride, chain saturated chlorinated hydrocarbons having 1 or more and 3 or less carbon atoms, and unsaturated chlorinated hydrocarbons having 2 or 3 carbon atoms.
[7] The etching method according to [4], in which the etching compound is the compound having a bromine atom in the molecule and is at least one type among hydrogen bromide, chain saturated brominated hydrocarbons having 1 or more and 3 or less carbon atoms, and unsaturated brominated hydrocarbons having 2 carbon atoms.
[8] The etching method according to [4], in which the etching compound is the compound having an iodine atom in the molecule and is at least one type among iodine heptafluoride, hydrogen iodide, trifluoroiodomethane, and pentafluoroiodoethane.
[9] The etching method according to [4], in which the etching compound is the compound having a hydrogen atom in the molecule and is at least one type among chain saturated hydrocarbons having 1 or more and 4 or less carbon atoms, unsaturated hydrocarbons having 2 or more and 4 or less carbon atoms, and cyclic hydrocarbons having 3 or 4 carbon atoms.

### Advantageous Effects of Invention

The present invention hardly causes the bowing and the etch stop.

### Brief Description of Drawings

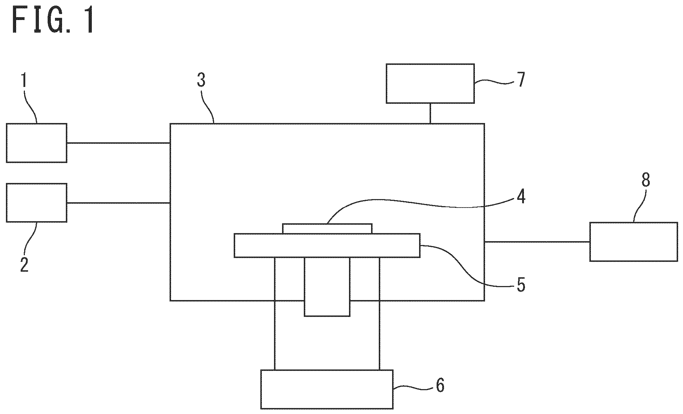

FIG. 1 is a schematic diagram of one example of an etching device for explaining one embodiment of an etching method according to the present invention.

### Description of Embodiments

Hereinafter, one embodiment of the present invention is described. This embodiment describes one example of the present invention, and the present invention is not limited to this embodiment. This embodiment can be variously altered or improved, and such altered or improved aspects can also be included in the present invention.

The etching method according to this embodiment has an etching step of setting the temperature of a member to be etched having an etching object containing silicon to 0°C or less, bringing an etching gas containing an etching compound into contact with the member to be etched, and etching the etching object. The etching gas contains or does not contain high-boiling-point impurities, the high-boiling-point impurities being compounds having at least one type of atom among a fluorine atom, a chlorine atom, a bromine atom, an iodine atom, a hydrogen atom, and an oxygen atom in the molecule and having a boiling point of 20°C or more under a pressure of 101 kPa, and, when the etching gas contains the high-boiling-point impurities, the total concentration of all types of the contained high-boiling-point impurities is 500 ppm by volume or less.

The boiling points of the high-boiling-point impurities and the etching compound are the boiling points under a pressure of 101 kPa (i.e., boiling points under atmospheric pressure), and are sometimes simply referred to as "boiling points" in the following description.

When the etching gas containing the above-described etching compound is brought into contact with the member to be etched, the etching object containing silicon and the above-described etching compound in the etching gas react with each other, and therefore the etching of the etching object progresses. In contrast thereto, a non-etching object, such as a mask, hardly reacts with the above-described etching compound, and therefore the etching of the non-etching object hardly progresses. Accordingly, the etching method according to this embodiment can selectively etch the etching object over the non-etching object (i.e., high etching selectivity is obtained).

The etching method according to this embodiment is a low-temperature etching method in which etching is performed at temperatures of 0°C or less, and therefore etching can be performed at a lower side etching rate. Further, according to the etching method of this embodiment, the etching gas does not contain the high-boiling-point impurities, or even when the etching gas contains the high-boiling-point impurities, the amount is very small, and therefore condensation of the high-boiling-point impurities hardly occurs even in the case of the low-temperature etching. Therefore, problems caused by the condensation of the high-boiling-point impurities hardly occur, and thus the etching rate and the etching selectivity are high.

For example, the condensation of the high-boiling-point impurities hardly occurs in a hole during etching for forming the hole and the flowing of the etching gas to a bottom part of the hole is hardly blocked, and therefore the etch stop hardly occurs and the etching rate is high. Further, the condensed impurities hardly become etchants and undesirable chemical etching hardly progresses, and therefore the bowing hardly occurs and the etching selectivity is high.

Accordingly, the etching method according to this embodiment can be utilized for the manufacture of a semiconductor element. For example, when the etching method according to this embodiment is applied to a semiconductor substrate having a thin film containing a silicon compound and the thin film containing a silicon compound is etched, a semiconductor element can be manufactured. The etching method according to this embodiment has high etching rate and etching selectivity, and therefore has high productivity of semiconductor elements.

The etching in the present invention refers to partially or entirely removing the etching object possessed by the member to be etched and processing the member to be etched into a specified shape (e.g., a three-dimensional shape) (e.g., processing a film-like etching object containing a silicon compound possessed by the member to be etched to have a predetermined film thickness).

Hereinafter, the etching method according to this embodiment is described in more detail.

### [Etching method]

For the etching method according to this embodiment, both plasma etching using a plasma or plasmaless etching using no plasma are usable. Examples of the plasma etching include reactive ion etching (RIE), inductively coupled plasma (ICP) etching, capacitively coupled plasma (CCP) etching, electron cyclotron resonance (ECR) plasma etching, and microwave plasma etching.

In the plasma etching, a plasma may be generated in a chamber where the member to be etched is placed or a plasma generating chamber and the chamber where the member to be etched is placed may be separated from each other (i.e., a remote plasma may be used). By etching using the remote plasma, the etching object containing silicon can be sometimes etched at a higher selectivity.

### [Etching compound]

The etching compound contained in the etching gas is a compound that reacts with the etching object containing silicon to make etching of the etching object progress. The type of the etching compound is not particularly limited insofar as it is a compound that makes the etching of the etching object progress, and is preferably a compound having at least one type of atom among a fluorine atom, a chlorine atom, a bromine atom, an iodine atom, and a hydrogen atom in the molecule and having a boiling point of 15°C or less under a pressure of 101 kPa.

The boiling point of the etching compound under a pressure of 101 kPa is preferably 15°C or less, more preferably 10°C or less, and still more preferably 0°C or less. Examples of the etching compound are described below.

Examples of the etching compound having a fluorine atom in the molecule include sulfur hexafluoride (SF₆), nitrogen trifluoride (NF₃), chlorine trifluoride (ClF₃), iodine heptafluoride (IF₇), phosphorus trifluoride (PF₃), silicon tetrafluoride (SiF₄), fluorine gas (F₂), trifluoroiodomethane (CF₃I), carbonyl fluoride (COF₂), trifluoromethyl hypofluoride (CF₃OF), chain saturated perfluorocarbons having 1 or more and 3 or less carbon atoms, chain saturated hydrofluorocarbons having 1 or more and 3 or less carbon atoms, unsaturated perfluorocarbons having 2 or more and 5 or less carbon atoms, unsaturated hydrofluorocarbons having 2 or more and 4 or less carbon atoms, cyclic perfluorocarbons having 3 or more and 5 or less carbon atoms, and cyclic hydrofluorocarbons having 3 or more and 5 or less carbon atoms.

Specific examples of the chain saturated perfluorocarbons having 1 or more and 3 or less carbon atoms include tetrafluoromethane (CF₄), hexafluoroethane (C₂F₆), and octafluoropropane (C₃F₈).

Specific examples of the chain saturated hydrofluorocarbons having 1 or more and 3 or less carbon atoms include fluoromethane (CH₃F), difluoromethane (CH₂F₂), trifluoromethane (CHF₃), fluoroethane (C₂H₅F), difluoroethane (C₂H₄F₂), trifluoroethane (C₂H₃F₃), tetrafluoroethane (C₂H₂F₄), pentafluoroethane (C₂HF₅), fluoropropane (C₃H₇F), difluoropropane (C₃H₆F₂), trifluoropropane (C₃H₅F₃), tetrafluoropropane (C₃H₄F₄), pentafluoropropane (C₃H₃F₅), hexafluoropropane (C₃H₂F₆), and heptafluoropropane (C₃HF₇).

Specific examples of the unsaturated perfluorocarbons having 2 or more and 5 or less carbon atoms include tetrafluoroethylene (C₂F₄), difluoroacetylene (C₂F₂), hexafluoropropylene (C₃F₆), tetrafluoropropyne (C₃F₄), octafluorobutene (C₄F₈), hexafluorobutyne (C₄F₆), and octafluoropentyne (C₅F₈).

Specific examples of the unsaturated hydrofluorocarbons having 2 or more and 4 or less carbon atoms include fluoroethylene (C₂H₃F), difluoroethylene (C₂H₂F₂), trifluoroethylene (C₂HF₃), fluoropropylene (C₃H₅F), difluoropropylene (C₃H₄F₂), trifluoropropylene (C₃H₃F₃), tetrafluoropropylene (C₃H₂F₄), pentafluoropropylene (C₃HF₅), fluoropropyne (C₃H₃F), difluoropropyne (C₃H₂F₂), trifluoropropyne (C₃HF₃), difluorobutene (C₄H₆F₂), trifluorobutene (C₄H₅F₃), pentafluorobutene (C₄H₃F₅), hexafluorobutene (C₄H₂F₆), heptafluorobutene (C₄HF₇), fluorobutyne (C₄H₅F), difluorobutyne (C₄H₄F₂), trifluorobutyne (C₄H₃F₃), tetrafluorobutyne (C₄H₂F₄), and pentafluorobutyne (C₄HF₅).

Specific examples of the cyclic perfluorocarbons having 3 or more and 5 or less carbon atoms include hexafluorocyclopropane (C₃F₆), octafluorocyclobutane (C₄F₈), and decafluorocyclopentane (C₅F₁₀).

Specific examples of the cyclic hydrofluorocarbons having 3 or more and 5 or less carbon atoms include fluorocyclopropane (C₃H₅F), difluorocyclopropane (C₃H₄F₂), trifluorocyclopropane (C₃H₃F₃), tetrafluorocyclopropane (C₃H₂F₄), pentafluorocyclopropane (C₃HF₅), and heptafluorocyclobutane (C₄HF₇).

In the present invention, the hydrofluorocarbons refer to compounds in which some of hydrogen atoms possessed by the hydrocarbons are substituted with fluorine atoms.

Examples of the etching compound having a chlorine atom in the molecule include boron trichloride (BCl₃), chlorine gas (Cl₂), hydrogen chloride (HCl), chlorine trifluoride (ClF₃), chain saturated chlorinated hydrocarbons having 1 or more and 3 or less carbon atoms, and unsaturated chlorinated hydrocarbons having 2 or 3 carbon atoms.

Specific example of the chain saturated chlorinated hydrocarbons having 1 or more and 3 or less carbon atoms include chloromethane (CH₃Cl), chlorodifluoromethane (CHClF₂), chlorofluoromethane (CH₂ClF), dichlorofluoromethane (CHCl₂F), chlorotrifluoromethane (CClF₃), dichlorodifluoromethane (CCl₂F₂), chloroethane (C₂H₅Cl), chlorodifluoroethane (C₂H₃ClF₂), chlorotetrafluoroethane (C₂HClF₄), chloropentafluoroethane (C₂ClF₅), dichlorotetrafluoroethane (C₂Cl₂F₄), chlorohexafluoropropane (C₃HClF₆), chloroheptafluoropropane (C₃ClF₇), and dichlorohexafluoropropane (C₃Cl₂F₆).

Specific examples of the unsaturated chlorinated hydrocarbons having 2 or 3 carbon atoms include chloroethylene (C₂H₃Cl), chlorofluoroethylene (C₂H₂ClF), chlorodifluoroethylene (C₂HClF₂), chlorotrifluoroethylene (C₂ClF₃), chlorotrifluoropropylene (C₃H₂ClF₃), chlorotetrafluoropropylene (C₃HClF₄), and chloropentafluoropropylene (C₃ClF₅).

Examples of the etching compound having a bromine atom in the molecule include hydrogen bromide (HBr), chain saturated brominated hydrocarbons having 1 or more and 3 or less carbon atoms, and unsaturated brominated hydrocarbons having 2 carbon atoms.

Specific examples of the chain saturated brominated hydrocarbons having 1 or more and 3 or less carbon atoms include bromomethane (CH₃Br), bromodifluoromethane (CHBrF₂), bromofluoromethane (CH₂BrF), bromotrifluoromethane (CBrF₃), bromotetrafluoroethane (C₂HBrF₄), bromopentafluoroethane (C₂BrF₅), and bromoheptafluoropropane (C₃BrF₇).

Specific examples of the unsaturated brominated hydrocarbons having 2 carbon atoms include bromofluoroethylene (C₂H₂BrF), bromodifluoroethylene (C₂HBrF₂), and bromotrifluoroethylene (C₂BrF₃).

Examples of the etching compound having an iodine atom in the molecule include iodine heptafluoride, hydrogen iodide (HI), trifluoroiodomethane, and pentafluoroiodoethane (C₂F₅I).

Examples of the etching compound having a hydrogen atom in the molecule include chain saturated hydrocarbons having 1 or more and 4 or less carbon atoms, unsaturated hydrocarbons having 2 or more and 4 or less carbon atoms, and cyclic hydrocarbons having 3 or 4 carbon atoms.

Specific examples of the chain saturated hydrocarbons having 1 or more and 4 or less carbon atoms include methane (CH₄), ethane (C₂H₆), propane (C₃H₈), and butane (C₄H₁₀).

Specific examples of the unsaturated hydrocarbons having 2 or more and 4 or less carbon atoms include ethylene (C₂H₄), acetylene (C₂H₂), propylene (C₃H₆), propyne (C₃H₄), butene (C₄H₈), and butyne (C₄H₆).

Specific examples of the cyclic hydrocarbons having 3 or 4 carbon atoms include cyclopropane (C₃H₆), cyclobutane (C₄H₈), and cyclobutene (C₄H₆).

These etching compounds may be used alone or in combination of two or more types thereof. Some of the etching compounds described above as specific examples have isomers. The isomers are all usable as the etching compound in the etching method according to this embodiment.

### [Etching gas]

The etching gas is gas containing the above-described etching compounds. The etching gas may be gas containing only the above-described etching compounds or may be mixed gas containing the above-described etching compounds and dilution gas. The etching gas may also be mixed gas containing the above-described etching compounds, dilution gas, and additive gas.

The type of the dilution gas is not particularly limited insofar as it is inert gas, and at least one type selected from nitrogen gas (N₂), helium (He), neon (Ne), argon (Ar), krypton (Kr), and xenon (Xe) is usable, for example.

The content of the dilution gas is preferably 90% by volume or less and more preferably 50% by volume or less based on the total amount of the etching gas. The content of the dilution gas is preferably 10% by volume or more based on the total amount of the etching gas.

From the viewpoint of increasing the etching rate, the content of the etching compound in the etching gas is preferably 5% by volume or more and more preferably 10% by volume or more based on the total amount of the etching gas. From the viewpoint of reducing the usage amount of the etching compound, the content of the etching compound is preferably 90% by volume or less and more preferably 80% by volume or less based on the total amount of the etching gas.

The etching gas can be obtained by mixing a plurality of components (etching compound, dilution gas, and the like) constituting the etching gas. The mixing of the plurality of components may be performed either inside or outside a chamber. More specifically, the plurality of components constituting the etching gas each may be independently introduced into a chamber and mixed in the chamber or the plurality of components constituting the etching gas may be mixed to obtain the etching gas, and the obtained etching gas may be introduced into the chamber.

### [High-boiling-point impurities]

The etching gas contains or does not contain the high-boiling-point impurities. When the etching gas contains the high-boiling-point impurities, the total concentration of all types of the contained high-boiling-point impurities is 500 ppm by volume or less based on the total amount of gasified etching gas. Therefore, problems caused by the condensation of the high-boiling-point impurities hardly occur, and the etching rate and the etching selectivity are high as described above. The total concentration of all types of the high-boiling-point impurities contained in the etching gas may be 0.01 ppm by volume or more and 300 ppm by volume or less. The concentrations of each of all types of the high-boiling-point impurities contained in the etching gas may be 0.01 ppm by volume or more.

In the present invention, the high-boiling-point impurities are compounds having at least one type of atom among a fluorine atom, a chlorine atom, a bromine atom, an iodine atom, a hydrogen atom, and an oxygen atom in the molecule and has a boiling point of 20°C or more under a pressure of 101 kPa. The etching gas or the etching compound sometimes contains one type or two or more types of the high-boiling-point impurities.

The concentration of the high-boiling-point impurities contained in the etching gas or the etching compound can be quantified with methods, such as gas chromatography, infrared spectroscopy, ultraviolet-visible spectroscopy, mass spectrometry, and the like. Herein, not containing the high-boiling-point impurities refers to a case where the quantification of the high-boiling-point impurities with any of the gas chromatography, the infrared spectroscopy, and the mass spectrometry is impossible.

Methods for removing the high-boiling-point impurities from the etching gas or the etching compound include, for example, a method including bringing the etching gas or the etching compound into contact with an adsorbent, a method including separating the etching gas or the etching compound with a film, or a method including separating the etching gas or the etching compound by distillation. A specific example of the method including separating the etching gas or the etching compound by distillation is described: the etching compound or the etching gas is sealed in a stainless steel cylinder and the temperature is kept at a temperature equal to or less than the boiling point of the etching compound under the internal pressure of the cylinder (e.g., when the etching compound is difluoromethane, the temperature is kept at -50°C under the internal pressure of the cylinder slightly higher than 1 atm), and a gas phase part is extracted using the method described in Examples described later or the like, and thus the high-boiling-point impurities can be separated. The etching gas may be used for etching after the total concentration of the high-boiling point impurities contained in the etching gas is reduced to 500 ppb by volume or less by such a step of removing the high-boiling point impurities.

The high-boiling-point impurities are prone to condensation during the low-temperature etching when the boiling point is 20°C or more and less than 200°C.

The total concentration of the high-boiling-point impurities having boiling points of 20°C or more and less than 60°C is required to be 500 ppm by volume or less, preferably 50 ppm by volume or less, and more preferably 1 ppm by volume or less based on the total amount of the gasified etching gas. The total concentration of the high-boiling-point impurities having boiling points of 20°C or more and less than 60°C may be 0.01 ppm by volume or more.

The type of the high-boiling-point impurities having boiling points of 20°C or more and less than 60°C is not particularly limited. Examples include hydrogen fluoride (HF, boiling point of 20°C), bromine molecules (Br₂, boiling point of 58.8°C), dichloromethane (CH₂Cl₂, boiling point of 40°C), trichlorotrifluoroethane (C₂Cl₃F₃, boiling point of 47.7°C), dichlorotrifluoroethane (C₂HCl₂F₃, boiling point of 27.8°C), dichlorofluoroethane (C₂H₃Cl₂F, boiling point of 32°C), iodomethane (CH₃I, boiling point of 42.4°C), and nitrogen dioxide (NO₂, boiling point of 21.1°C).

The total concentration of the high-boiling-point impurities having boiling points of 60°C or more and less than 100°C is required to be 500 ppm by volume or less, preferably 50 ppm by volume or less, and more preferably 1 ppm by volume or less based on the total amount of the gasified etching gas. The total concentration of the high-boiling-point impurities having boiling points of 60°C or more and less than 100°C may be 0.01 ppm by volume or more.

The type of the high-boiling-point impurities having boiling points of 60°C or more and less than 100°C is not particularly limited. Examples include ethanol (CH₃CH₂OH, boiling point of 78°C), isopropanol (C₃H₇OH, boiling point of 82.4°C), chloroform (CHCl₃, boiling point of 61.2°C), tetrachlorodifluoroethane (C₂Cl₄F₂, boiling point of 92.8°C), benzene (C₆H₆, boiling point of 80°C), cyclohexane (C₆H₁₂, boiling point of 81°C), hexafluorobenzene (C₆F₆, boiling point of 80.5°C), tetrachloroethylene (C₂Cl₄, boiling point of 87.2°C), and phosphorus trichloride (PCl₃, boiling point of 74°C).

The total concentration of the high-boiling-point impurities having boiling points of 100°C or more and less than 200°C is required to be 500 ppm by volume or less, preferably 50 ppm by volume or less, and more preferably 1 ppm by volume or less based on the total amount of the gasified etching gas. The total concentration of the high-boiling-point impurities having boiling points of 100°C or more and less than 200°C may be 0.01 ppm by volume or more.

The type of the high-boiling-point impurities having boiling points of 100°C or more and less than 200°C is not particularly limited. Examples include water (H₂O, boiling point of 100°C), iodine molecules (I₂, boiling point of 184.3°C), carbon tetrabromide (CBr₄, boiling point of 190°C), tribromofluoromethane (CBr₃F, boiling point of 108°C), iodine pentafluoride (IF₅, boiling point of 104°C), and phosphorus tribromide (PBr₃, boiling point of 173.2°C).

When the etching gas contains the high-boiling-point impurities, the number of the contained high-boiling-point impurities may be one type or two more types. Examples of the etching gas containing the high-boiling-point impurities particularly include an etching gas containing at least one type among water, hydrogen fluoride, ethanol, isopropanol, chloroform, dichloromethane, cyclohexane, benzene, iodine molecules, and bromine molecules. Some of the high-boiling-point impurities described above as specific examples have isomers. The isomers are all included in the high-boiling-point impurities in the etching method according to this embodiment.

The etching gas may contain compounds having boiling points of less than 20°C as impurities. The total concentration of the impurities having boiling points of less than 20°C is preferably 1000 ppm by volume or less, more preferably 50 ppm by volume or less, and still more preferably 1 ppm by volume or less based on the total amount of the gasified etching gas. The total concentration of the impurities having boiling points of less than 20°C may be 0.01 ppm by volume or more.

### [Temperature condition of etching step]

The etching method according to this embodiment is a low-temperature etching, and therefore etching is performed after the temperature of the member to be etched is set to 0°C or less. The temperature of the member to be etched is preferably set to -20°C or less and more preferably set to -40°C or less. When etching is performed after the temperature of the member to be etched is set within the range above, the etching can be performed at a lower side etching rate.

Herein, the temperature of the temperature condition is the temperature of the member to be etched, but the temperature of a stage, which is installed in a chamber of an etching device and supports the member to be etched, is also usable.

A bias power constituting a potential difference between a plasma generated when etching is performed and the member to be etched can be selected from 0 to 10000 W according to a desired etching shape. When etching is selectively performed, the bias power is preferably about 0 to 1000 W.

### [Pressure condition of etching step]

The pressure condition of the etching step in the etching method according to this embodiment is not particularly limited, and is preferably set to 10 Pa or less and more preferably set to 5 Pa or less. When the pressure condition is within the range above, a plasma is likely to be stably generated. The pressure condition of the etching step is preferably 0.05 Pa or more. When the pressure condition is within the range above, a large number of ionization ions are generated and a sufficient plasma density is likely to be obtained.

The flow rate of the etching gas may be set as appropriate such that the pressure in a chamber is kept constant according to the volume of the chamber or the capacity of an exhaust facility of reducing the pressure in the chamber.

### [Member to be etched]

The member to be etched that is etched by the etching method according to this embodiment has the etching object that is an object to be etched and may further contain a non-etching object that is not an object to be etched.

When the member to be etched has the etching object and the non-etching object, the member to be etched may be a member having a portion formed of the etching object and a portion formed of the non-etching object or may be a member formed of a mixture of the etching object and the non-etching object. The member to be etched may have things other than the etching object and the non-etching object.

The shape of the member to be etched is not particularly limited and may be a plate shape, a foil shape, a film shape, a powder shape, or a block shape, for example. Examples of the member to be etched include the above-described semiconductor substrate.

### [Etching object]

The etching object may be formed of only materials containing silicon, may have a portion formed of only materials containing silicon and a portion formed of other materials, or may be formed of a mixture of materials containing silicon and other materials. Examples of the materials containing silicon include silicon oxide, silicon nitride, polysilicon, and silicon germanium (SiGe), for example. The materials containing silicon may be used alone or in combination of two or more types thereof.

Examples of silicon oxide include silicon dioxide (SiO₂). Silicon nitride refers to a compound having silicon and nitrogen in an optional ratio, and includes Si₃N₄, for example. The purity of silicon nitride is not particularly limited, and is preferably 30% by mass or more, more preferably 60% by mass or more, and still more preferably 90% by mass or more.

The shape of the etching object is not particularly limited and may be a plate shape, a foil shape, a film shape, a powder shape, or a block shape, for example. The etching object may or may not have shapes, such as patterns or holes, formed therein.

### [Non-etching object]

The non-etching object does not substantially react with the above-described etching compounds or extremely slowly reacts with the above-described etching compounds. Therefore, even when etching is performed by the etching method according to this embodiment, the etching hardly progresses. The non-etching object is not particularly limited insofar as it has the above-described properties. Examples include a photoresist, amorphous carbon, titanium nitride, metals, such as copper, nickel, and cobalt, and oxides and nitrides of these metals. Among the above, a photoresist and amorphous carbon are more preferable from the viewpoint of ease of handling properties and availability.

The non-etching object is usable as a resist or a mask for suppressing the etching of the etching object by the etching gas. Thus, the etching method according to this embodiment can be utilized for a method including processing the etching object into a predetermined shape (e.g., processing the etching object in a film shape possessed by the member to be etched to have a predetermined film thickness), for example, utilizing the patterned non-etching object as the resist or the mask, and therefore is suitably usable for the manufacture of semiconductor elements. The non-etching object is hardly etched, and therefore etching of a portion that should not be essentially etched of a semiconductor element can be suppressed and the loss of the characteristics of a semiconductor element by etching can be prevented.

Next, one example of the configuration of an etching device capable of implementing the etching method according to this embodiment and one example of an etching method using the etching device are described with reference to FIG. 1. The etching device in FIG. 1 is a plasma etching device for performing etching using a plasma. First, the etching device in FIG. 1 is described.

The etching device in FIG. 1 includes a chamber 3 inside which etching is performed, a plasma generating device (not illustrated) generating a plasma into the chamber 3, a stage 5 supporting a member to be etched 4 that is etched inside the chamber 3, a cooling section 6 cooling the member to be etched 4 through the stage 5, a thermometer (not illustrated) measuring the temperature of the member to be etched 4, a vacuum pump 8 reducing the pressure inside the chamber 3, and a pressure gauge 7 measuring the pressure inside the chamber 3.

The type of a plasma generating mechanism of the plasma generating device is not particularly limited, and may be one applying a high-frequency voltage to parallel plates or one passing a high-frequency current through a coil. When a high-frequency voltage is applied to the member to be etched 4 in a plasma, a negative voltage is applied to the member to be etched 4, and positive ions are incident on the member to be etched 4 at high speed and perpendicularly, making anisotropic etching possible. In the etching device in FIG. 1, the stage 5 and a high frequency power supply of the plasma generating device are connected to each other, and a high frequency voltage can be applied to the stage 5.

The etching device in FIG. 1 includes an etching gas supply section supplying an etching gas to the chamber 3. The etching gas supply section has an etching compound gas supply section 1 supplying an etching compound gas, a dilution gas supply section 2 supplying dilution gas, a pipe connecting the etching compound gas supply section 1 and the chamber 3, and a pipe connecting the dilution gas supply section 2 and the chamber 3. A facility supplying additive gas may also be provided (not illustrated) in a form similar to that of the dilution gas supply section 2. The gas, such as the etching gas, supplied into the chamber 3 can be discharged out of the chamber 3 through an exhaust pipe, which is not illustrated.

When the etching compound gas is used as the etching gas, the etching compound gas may be supplied to the chamber 3 through a pipe by feeding out the etching compound gas from the etching compound gas supply section 1 after the inside of the chamber 3 is depressurized with the vacuum pump 8.

When a mixture of the etching compound gas and the dilution gas, such as inert gas, is used as the etching gas, the etching compound gas may be fed out from the etching compound gas supply section 1 and the dilution gas may be fed out from the dilution gas supply section 2 after the inside of the chamber 3 is depressurized with the vacuum pump 8. Thus, the etching compound gas and the dilution gas are mixed in the chamber 3 to form the etching gas.

The etching method according to this embodiment can be implemented using a common plasma etching device used in a semiconductor element manufacturing process, such as the etching device in FIG. 1, and the configurations of usable etching devices are not limited.

For example, the configuration of a temperature control mechanism of the chamber 3 may be a configuration in which the stage 5 is cooled from the outside of the chamber 3 with an external cooling section 6 as in the etching device in FIG. 1 or may be a configuration in which a cooling section cooling the stage 5 is provided directly on the stage 5 because the temperature of the member to be etched 4 only needs to be controlled to an optional temperature.

### EXAMPLES

The present invention is more specifically described with reference to Examples and Comparative Examples below. Etching compound gases containing various concentrations of high-boring point impurities were prepared. Preparation Examples of the etching compound gases are described below.

### (Preparation Example 1)

Five 1 L volume manganese steel cylinders (sealable cylindrical containers) were prepared. The cylinders are referred to as a cylinder A, a cylinder B, a cylinder C, a cylinder D, and a cylinder E in order. The cylinder A was filled with 500 g of difluoromethane (boiling point at a pressure of 101 kPa: -52°C). The difluoromethane was liquefied by being cooled to -50°C, forming a liquid phase part and a gas phase part in a pressurized state slightly higher than 100 kPa. The cylinders B, C, D, E were cooled to -196°C after the inside was depressurized to 1 kPa or less with a vacuum pump.

400 g of difluoromethane gas was extracted from an upper outlet, where the gas phase part is present, of the cylinder A, and transferred to the cylinder B in the depressurized state. 100 g of the difluoromethane remaining in the cylinder A is set as Sample 1-1. Thereafter, the difluoromethane gas remaining in the cylinder A was extracted from the upper outlet, and the concentrations of various impurities, such as the high-boiling-point impurities, were measured with infrared spectroscopy and gas chromatography. The results are shown in Table 1. The concentrations of the impurities were measured with infrared spectroscopy for hydrogen fluoride and water and with gas chromatography for dichloromethane and trifluoromethane.

**[Table 1]**

| | Hydrogen fluoride | Water | Dichloromethane | Trifluoromethane |
|---|---|---|---|---|
| | Boiling point of 20°C | Boiling point of 100°C | Boiling point of 40°C | Boiling point of -82°C |
| Sample 1-1 | 9523 | 5329 | 8492 | 1 |
| Sample 1-2 | 1225 | 483 | 1103 | 17 |
| Sample 1-3 | 203 | 68 | 174 | 187 |
| Sample 1-4 | 54 | 8 | 32 | 983 |
| Sample 1-5 | 6 | 1 | 4 | 5822 |

| | | | | |
|---|---|---|---|---|
| *) Unit of numerical values is ppb by volume. | | | | |

Next, the temperature of the cylinder B was raised to -50°C, forming a liquid phase part and a gas phase part. 300 g of the difluoromethane gas was extracted from an upper outlet, where the gas phase part is present, of the cylinder B and transferred to the cylinder C in the depressurized state. 100 g of the difluoromethane remaining in the cylinder B is set as Sample 1-2. Thereafter, the difluoromethane gas remaining in the cylinder B was extracted from the upper outlet, and the concentrations of various impurities, such as the high-boiling-point impurities, were measured with infrared spectroscopy and gas chromatography. The results are shown in Table 1.

Further, the temperature of the cylinder C was raised to -50°C, forming a liquid phase part and a gas phase part. 200 g of the difluoromethane gas was extracted from an upper outlet, where the gas phase part is present, of the cylinder C and transferred to the cylinder D in the depressurized state. 100 g of the difluoromethane remaining in the cylinder C is set as Sample 1-3. Thereafter, the difluoromethane gas remaining in the cylinder C was extracted from the upper outlet, and the concentrations of various impurities, such as the high-boiling-point impurities, were measured with infrared spectroscopy and gas chromatography. The results are shown in Table 1.

Further, the temperature of the cylinder D was raised to -50°C, forming a liquid phase part and a gas phase part. 100 g of the difluoromethane gas was extracted from an upper outlet, where the gas phase part is present, of the cylinder D and transferred to the cylinder E in the depressurized state. 100 g of the difluoromethane remaining in the cylinder D is set as Sample 1-4. Thereafter, the difluoromethane gas remaining in the cylinder D was extracted from the upper outlet, and the concentrations of various impurities, such as the high-boiling-point impurities, were measured with infrared spectroscopy and gas chromatography. The results are shown in Table 1.

Further, 100 g of the difluoromethane in the cylinder E is set as Sample 1-5. The difluoromethane gas was extracted from an upper outlet, where the gas phase part is present, of the cylinder E, and the concentrations of various impurities, such as the high-boiling-point impurities, were measured with infrared spectroscopy and gas chromatography. The results are shown in Table 1.

### (Preparation Example 2)

Samples 2-1 to 2-5 were prepared by performing the same operation as in Preparation Example 1, except that chlorine gas (boiling point at a pressure of 101 kPa: - 34°C) was used as the etching compound and the liquefaction temperature was set to -30°C. Then, the concentrations of various impurities, such as the high-boiling-point impurities, contained in each of the samples were measured with infrared spectroscopy and gas chromatography. The results are shown in Table 2. The concentrations of the impurities were measured with infrared spectroscopy for hydrogen chloride and water and with gas chromatography for dichloromethane and chloroform.

**[Table 2]**

| | Dichloromethane | Chloroform | Water | Hydrogen chloride |
|---|---|---|---|---|
| | Boiling point of 40°C | Boiling point of 61°C | Boiling point of 100°C | Boiling point of -85° C |
| Sample 2-1 | 6411 | 1582 | 10437 | 1 |
| Sample 2-2 | 1252 | 288 | 1003 | 5 |
| Sample 2-3 | 203 | 64 | 105 | 37 |
| Sample 2-4 | 33 | 15 | 12 | 403 |
| Sample 2-5 | 7 | 4 | 2 | 2873 |

| | | | | |
|---|---|---|---|---|
| *) Unit of numerical values is ppb by volume. | | | | |

### (Preparation Example 3)

Samples 3-1 to 3-5 were prepared by performing the same operation as in Preparation Example 1, except that hydrogen bromide (boiling point at a pressure of 101 kPa: -66°C) was used as the etching compound and the liquefaction temperature was set to -60°C. Then, the concentrations of various impurities, such as the high-boiling-point impurities, contained in each of the samples were measured with infrared spectroscopy, gas chromatography, and mass spectrometry. The results are shown in Table 3. The concentrations of the impurities were measured with infrared spectroscopy for water, with gas chromatography for carbon dioxide, and with mass spectrometry for bromine molecules.

**[Table 3]**

| | Bromine | Water | Carbon dioxide |
|---|---|---|---|
| | Boiling point of 58.5°C | Boiling point of 100°C | Boiling point of -78.5°C |
| Sample 3-1 | 12048 | 11092 | 4 |
| Sample 3-2 | 1921 | 1021 | 21 |
| Sample 3-3 | 224 | 98 | 98 |
| Sample 3-4 | 36 | 10 | 873 |
| Sample 3-5 | 8 | 1 | 5729 |

| | | | |
|---|---|---|---|
| *) Unit of numerical values is ppb by volume. | | | |

### (Preparation Example 4)

Samples 4-1 to 4-5 were prepared by performing the same operation as in Preparation Example 1, except that trifluoroiodomethane (boiling point at a pressure of 101 kPa: -23°C) was used as the etching compound and the liquefaction temperature was set to -20°C. Then, the concentrations of various impurities, such as the high-boiling-point impurities, contained in each of the samples were measured with infrared spectroscopy and mass spectrometry. The results are shown in Table 4. The concentrations of the impurities were measured with infrared spectroscopy for water, hydrogen fluoride, and hydrogen iodide and with mass spectrometry for iodine molecules.

**[Table 4]**

| | Iodine | Water | Hydrogen fluoride | Hydrogen iodide |
|---|---|---|---|---|
| | Boiling point of 184.3°C | Boiling point of 100°C | Boiling point of 20°C | Boiling point of -35°C |
| Sample 4-1 | 14032 | 5031 | 4288 | 51 |
| Sample 4-2 | 1014 | 783 | 1108 | 134 |
| Sample 4-3 | 114 | 94 | 210 | 382 |
| Sample 4-4 | 9 | 11 | 61 | 1082 |
| Sample 4-5 | 1 | 2 | 15 | 3243 |

| | | | | |
|---|---|---|---|---|
| *) Unit of numerical values is ppb by volume. | | | | |

### (Preparation Example 5)

Samples 5-1 to 5-5 were prepared by performing the same operation as in Preparation Example 1, except that propylene (boiling point at a pressure of 101 kPa: -48°C) was used as the etching compound and the liquefaction temperature was set to -45°C. Then, the concentrations of various impurities, such as the high-boiling-point impurities, contained in each of the samples were measured with infrared spectroscopy and gas chromatography. The results are shown in Table 5. The concentrations of the impurities were measured with infrared spectroscopy for water and with gas chromatography for benzene, cyclohexane, and ethane.

**[Table 5]**

| | Benzene | Cyclohexane | Water | Ethane |
|---|---|---|---|---|
| | Boiling point of 80°C | Boiling point of 81°C | Boiling point of 100°C | Boiling point of -89° C |
| Sample 5-1 | 9374 | 8203 | 12076 | 3 |
| Sample 5-2 | 1052 | 983 | 1186 | 13 |
| Sample 5-3 | 114 | 108 | 110 | 121 |
| Sample 5-4 | 14 | 9 | 13 | 913 |
| Sample 5-5 | 3 | 2 | 3 | 5722 |

| | | | | |
|---|---|---|---|---|
| *) Unit of numerical values is ppb by volume. | | | | |

### (Example 1)

On the surface of a semiconductor wafer, a 1000 nm thick silicon nitride film was formed, and a 500 nm thick resist film was further formed thereon. By performing exposure and development, a hole having a diameter of 200 nm was formed in the resist film, and the resultant semiconductor wafer was set as a test piece. Then, the test piece was etched using an etching gas.

As an etching device, an ICP etching device RIE-230iP manufactured by Samco Inc., was used. Specifically, the etching gas was prepared by independently introducing each of the difluoromethane of Sample 1-5 at a flow rate of 10 mL/min and argon at a flow rate of 40 mL/min into a chamber and mixing them in the chamber.

Next, a high-frequency voltage was applied at 500 W to convert the etching gas into a plasma in the chamber. Then, the test piece in the chamber was etched for 1 minute under etching conditions of a pressure of 3 Pa, a test piece temperature of -50°C, and a bias power of 100 W.

When the etching was completed, the temperature of the test piece was set to 20°C and argon was introduced into the chamber at a flow rate of 40 mL/min to purge the surface of the test piece.

When the purge was completed, the test piece was taken out from the chamber and cut. The cross section was observed with a scanning electron microscope, the thickness of the silicon nitride film was measured, and the etching rate of the silicon nitride film was calculated. Further, it was confirmed whether the bowing and the etch stop occurred. The results are shown in Table 6. As shown in Table 6, it was confirmed that the etching normally progressed at an etching rate of 84 nm/min without the occurrence of the bowing and the etch stop. The occurrence or non-occurrence of the bowing and the etch stop was determined from the observation results of the cross section with the scanning electron microscope.

**[Table 6]**

| | Etching compound | Sample No. | High-boiling-point impurities (ppm by volume) | Temperature (°C) | Etching rate (nm/min) | Bowing | Etch stop |
|---|---|---|---|---|---|---|---|
| Ex. 1 | CH₂F₂ | 1-5 | 2 | -50 | 84 | Not-occurred | Not-occurred |
| Ex. 2 | CH₂F₂ | 1-5 | 2 | -5 | 80 | Not-occurred | Not-occurred |
| Ref. Ex. 1 | CH₂F₂ | 1-5 | 2 | 25 | 79 | Not-occurred | Not-occurred |
| Ex. 3 | CH₂F₂ | 1-4 | 19 | -50 | 87 | Not-occurred | Not-occurred |
| Ex. 4 | CH₂F₂ | 1-3 | 89 | -50 | 91 | Not-occurred | Not-occurred |
| Comp. Ex. 1 | CH₂F₂ | 1-2 | 562 | -50 | 83 | Occurred | Not-occurred |
| Comp. Ex. 2 | CH₂F₂ | 1-1 | 4669 | -50 | 33 | Occurred | Occurred |
| Comp. Ex. 3 | CH₂F₂ | 1-1 | 4669 | -5 | 81 | Occurred | Slightly occurred |
| Comp. Ex. 4 | CH₂F₂ | 1-1 | 4669 | 25 | 74 | Occurred | Not-occurred |
| Ex. 5 | Cl₂ | 2-5 | 3 | -50 | 121 | Not-occurred | Not-occurred |
| Ex. 6 | Cl₂ | 2-4 | 12 | -50 | 118 | Not-occurred | Not-occurred |
| Ex. 7 | Cl₂ | 2-3 | 74 | -50 | 119 | Not-occurred | Not-occurred |
| Comp. Ex. 5 | Cl₂ | 2-2 | 509 | -50 | 47 | Not-occurred | Occurred |
| Comp. Ex. 6 | Cl₂ | 2-1 | 3686 | -50 | 32 | Not-occurred | Occurred |
| Ex. 8 | HBr | 3-5 | 2 | -50 | 63 | Not-occurred | Not-occurred |
| Ex. 9 | HBr | 3-4 | 9 | -50 | 67 | Not-occurred | Not-occurred |
| Ex. 10 | HBr | 3-3 | 64 | -50 | 64 | Not-occurred | Not-occurred |
| Comp. Ex. 7 | HBr | 3-2 | 588 | -50 | 28 | Not-occurred | Occurred |
| Comp. Ex. 8 | HBr | 3-1 | 4628 | -50 | 21 | Not-occurred | Occurred |
| Ex. 11 | CF₃I | 4-5 | 4 | -50 | 71 | Not-occurred | Not-occurred |
| Ex. 12 | CF₃I | 4-4 | 16 | -50 | 74 | Not-occurred | Not-occurred |
| Ex. 13 | CF₃I | 4-3 | 84 | -50 | 81 | Not-occurred | Not-occurred |
| Comp. Ex. 9 | CF₃I | 4-2 | 581 | -50 | 33 | Occurred | Occurred |
| Comp. Ex. 10 | CF₃I | 4-1 | 4670 | -50 | 18 | Occurred | Occurred |
| Ex. 14 | C₃H₆ + CF₄ | 5-5 | 2 | -50 | 137 | Not-occurred | Not-occurred |
| Ex. 15 | C₃H₆ + CF₄ | 5-4 | 7 | -50 | 133 | Not-occurred | Not-occurred |
| Ex. 16 | C₃H₆ + CF₄ | 5-3 | 66 | -50 | 134 | Not-occurred | Not-occurred |
| Comp. Ex. 11 | C₃H₆ + CF₄ | 5-2 | 644 | -50 | 42 | Not-occurred | Occurred |
| Comp. Ex. 12 | C₃H₆ + CF₄ | 5-1 | 5931 | -50 | 39 | Not-occurred | Occurred |

### (Example 2)

The test piece was etched by performing the same operation as in Example 1, except that the temperature of the test piece was set to -5°C. Table 6 shows the etching rate of the silicon nitride film and the result of confirming whether the bowing and the etch stop occurred. As shown in Table 6, it was confirmed that the etching normally progressed at an etching rate of 80 nm/min without the occurrence of the bowing and the etch stop.

### (Reference Example 1)

The test piece was etched by performing the same operation as in Example 1, except that the temperature of the test piece was set to 25°C. Table 6 shows the etching rate of the silicon nitride film and the result of confirming whether the bowing and the etch stop occurred. As shown in Table 6, it was confirmed that the etching normally progressed at an etching rate of 79 nm/min without the occurrence of the bowing and the etch stop.

### (Example 3)

The test piece was etched by performing the same operation as in Example 1, except that the difluoromethane of Sample 1-4 was used in place of the difluoromethane of Sample 1-5. Table 6 shows the etching rate of the silicon nitride film and the result of confirming whether the bowing and the etch stop occurred. As shown in Table 6, it was confirmed that the etching normally progressed at an etching rate of 87 nm/min without the occurrence of the bowing and the etch stop.

### (Example 4)

The test piece was etched by performing the same operation as in Example 1, except that the difluoromethane of Sample 1-3 was used in place of the difluoromethane of Sample 1-5. Table 6 shows the etching rate of the silicon nitride film and the result of confirming whether the bowing and the etch stop occurred. As shown in Table 6, it was confirmed that the etching normally progressed at an etching rate of 91 nm/min without the occurrence of the bowing and the etch stop.

### (Comparative Example 1)

The test piece was etched by performing the same operation as in Example 1, except that the difluoromethane of Sample 1-2 was used in place of the difluoromethane of Sample 1-5. Table 6 shows the etching rate of the silicon nitride film and the result of confirming whether the bowing and the etch stop occurred. As shown in Table 6, the occurrence of the bowing, in which the diameter of the hole increases, was observed in a part directly under the resist film of the silicon nitride film, and it was confirmed that lateral etching progressed. The etching rate was 83 nm/min.

### (Comparative Example 2)

The test piece was etched by performing the same operation as in Example 1, except that the difluoromethane of Sample 1-1 was used in place of the difluoromethane of Sample 1-5. Table 6 shows the etching rate of the silicon nitride film and the result of confirming whether the bowing and the etch stop occurred. As shown in Table 6, the occurrence of the bowing, in which the diameter of the hole increases, was observed in a part directly under the resist film of the silicon nitride film, and it was confirmed that lateral etching progressed. The etching rate was 33 nm/min and the occurrence of the etch stop was confirmed.

### (Comparative Example 3)

The test piece was etched by performing the same operation as in Example 1, except that the temperature of the test piece was set to -5°C. Table 6 shows the etching rate of the silicon nitride film and the result of confirming whether the bowing and the etch stop occurred. As shown in Table 6, the occurrence of the bowing, in which the diameter of the hole increases, was observed in a part directly under the resist film of the silicon nitride film, and it was confirmed that lateral etching progressed. The etching rate was 81 nm/min.

### (Comparative Example 4)

The test piece was etched by performing the same operation as in Example 1, except that the temperature of the test piece was set to 25°C. Table 6 shows the etching rate of the silicon nitride film and the result of confirming whether the bowing and the etch stop occurred. As shown in Table 6, the occurrence of the bowing, in which the diameter of the hole increases, was observed in a part directly under the resist film of the silicon nitride film, and it was confirmed that lateral etching progressed. The etching rate was 74 nm/min.

### (Example 5)

The test piece was etched by performing the same operation as in Example 1, except that a 1000 nm thick polysilicon film was formed in place of the 1000 nm thick silicon nitride film and the chlorine gas of Sample 2-5 was used in place of the difluoromethane of Sample 1-5. Table 6 shows the etching rate of the polysilicon film and the result of confirming whether the bowing and the etch stop occurred. As shown in Table 6, it was confirmed that the etching normally progressed at an etching rate of 121 nm/min without the occurrence of the bowing and the etch stop.

### (Example 6)

The test piece was etched by performing the same operation as in Example 5, except that the chlorine gas of Sample 2-4 was used in place of the chlorine gas of Sample 2-5. Table 6 shows the etching rate of the polysilicon film and the result of confirming whether the bowing and the etch stop occurred. As shown in Table 6, it was confirmed that the etching normally progressed at an etching rate of 118 nm/min without the occurrence of the bowing and the etch stop.

### (Example 7)

The test piece was etched by performing the same operation as in Example 5, except that the chlorine gas of Sample 2-3 was used in place of the chlorine gas of Sample 2-5. Table 6 shows the etching rate of the polysilicon film and the result of confirming whether the bowing and the etch stop occurred. As shown in Table 6, it was confirmed that the etching normally progressed at an etching rate of 119 nm/min without the occurrence of the bowing and the etch stop.

### (Comparative Example 5)

The test piece was etched by performing the same operation as in Example 5, except that the chlorine gas of Sample 2-2 was used in place of the chlorine gas of Sample 2-5. Table 6 shows the etching rate of the polysilicon film and the result of confirming whether the bowing and the etch stop occurred. As shown in Table 6, the etching rate was 47 nm/min and the occurrence of the etch stop was confirmed.

### (Comparative Example 6)

The test piece was etched by performing the same operation as in Example 5, except that the chlorine gas of Sample 2-1 was used in place of the chlorine gas of Sample 2-5. Table 6 shows the etching rate of the polysilicon film and the result of confirming whether the bowing and the etch stop occurred. As shown in Table 6, the etching rate was 32 nm/min and the occurrence of the etch stop was confirmed.

### (Example 8)

The test piece was etched by performing the same operation as in Example 1, except that a 1000 nm thick polysilicon film was formed in place of the 1000 nm thick silicon nitride film and the hydrogen bromide of Sample 3-5 was used in place of the difluoromethane of Sample 1-5. Table 6 shows the etching rate of the polysilicon film and the result of confirming whether the bowing and the etch stop occurred. As shown in Table 6, it was confirmed that the etching normally progressed at an etching rate of 63 nm/min without the occurrence of the bowing and the etch stop.

### (Example 9)

The test piece was etched by performing the same operation as in Example 8, except that the hydrogen bromide of Sample 3-4 was used in place of the hydrogen bromide of Sample 3-5. Table 6 shows the etching rate of the polysilicon film and the result of confirming whether the bowing and the etch stop occurred. As shown in Table 6, it was confirmed that the etching normally progressed at an etching rate of 67 nm/min without the occurrence of the bowing and the etch stop.

### (Example 10)

The test piece was etched by performing the same operation as in Example 8, except that the hydrogen bromide of Sample 3-3 was used in place of the hydrogen bromide of Sample 3-5. Table 6 shows the etching rate of the polysilicon film and the result of confirming whether the bowing and the etch stop occurred. As shown in Table 6, it was confirmed that the etching normally progressed at an etching rate of 64 nm/min without the occurrence of the bowing and the etch stop.

### (Comparative Example 7)

The test piece was etched by performing the same operation as in Example 8, except that the hydrogen bromide of Sample 3-2 was used in place of the hydrogen bromide of Sample 3-5. Table 6 shows the etching rate of the polysilicon film and the result of confirming whether the bowing and the etch stop occurred. As shown in Table 6, the etching rate was 28 nm/min and the occurrence of the etch stop was confirmed.

### (Comparative Example 8)

The test piece was etched by performing the same operation as in Example 8, except that the hydrogen bromide of Sample 3-1 was used in place of the hydrogen bromide of Sample 3-5. Table 6 shows the etching rate of the polysilicon film and the result of confirming whether the bowing and the etch stop occurred. As shown in Table 6, the etching rate was 21 nm/min and the occurrence of the etch stop was confirmed.

### (Example 11)

The test piece was etched by performing the same operation as in Example 1, except that a 1000 nm thick silicon oxide film was formed in place of the 1000 nm thick silicon nitride film and the trifluoroiodomethane of Sample 4-5 was used in place of the difluoromethane of Sample 1-5. Table 6 shows the etching rate of the silicon oxide film and the result of confirming whether the bowing and the etch stop occurred. As shown in Table 6, it was confirmed that the etching normally progressed at an etching rate of 71 nm/min without the occurrence of the bowing and the etch stop.

### (Example 12)

The test piece was etched by performing the same operation as in Example 11, except that the trifluoroiodomethane of Sample 4-4 was used in place of the trifluoroiodomethane of Sample 4-5. Table 6 shows the etching rate of the silicon oxide film and the result of confirming whether the bowing and the etch stop occurred. As shown in Table 6, it was confirmed that the etching normally progressed at an etching rate of 74 nm/min without the occurrence of the bowing and the etch stop.

### (Example 13)

The test piece was etched by performing the same operation as in Example 11, except that the trifluoroiodomethane of Sample 4-3 was used in place of the trifluoroiodomethane of Sample 4-5. Table 6 shows the etching rate of the silicon oxide film and the result of confirming whether the bowing and the etch stop occurred. As shown in Table 6, it was confirmed that the etching normally progressed at an etching rate of 81 nm/min without the occurrence of the bowing and the etch stop.

### (Comparative Example 9)

The test piece was etched by performing the same operation as in Example 11, except that the trifluoroiodomethane of Sample 4-2 was used in place of the trifluoroiodomethane of Sample 4-5. Table 6 shows the etching rate of the silicon oxide film and the result of confirming whether the bowing and the etch stop occurred. As shown in Table 6, the occurrence of the bowing, in which the diameter of the hole increases, was observed in a part directly under the resist film of the silicon oxide film and it was confirmed that lateral etching progressed. The etching rate was 33 nm/min and the occurrence of the etch stop was confirmed.

### (Comparative Example 10)

The test piece was etched by performing the same operation as in Example 11, except that the trifluoroiodomethane of Sample 4-1 was used in place of the trifluoroiodomethane of Sample 4-5. Table 6 shows the etching rate of the silicon oxide film and the result of confirming whether the bowing and the etch stop occurred. As shown in Table 6, the occurrence of the bowing, in which the diameter of the hole increases, was observed in a part directly under the resist film of the silicon oxide film and it was confirmed that lateral etching progressed. The etching rate was 18 nm/min and the occurrence of the etch stop was confirmed.

### (Example 14)

The test piece was etched by performing the same operation as in Example 1, except that a mixture of the propylene of Sample 5-5 and tetrafluoromethane having a purity of 99.99% by volume was used in place of the difluoromethane of Sample 1-5. In detail, the etching gas was prepared by independently introducing each of the propylene of Sample 5-5 at a flow rate of 10 mL/min, the tetrafluoromethane at a flow rate of 10 mL/min, and argon at a flow rate of 30 mL/min into a chamber and mixing them in the chamber.

Table 6 shows the etching rate of the silicon nitride film and the result of confirming whether the bowing and the etch stop occurred. As shown in Table 6, it was confirmed that the etching normally progressed at an etching rate of 137 nm/min without the occurrence of the bowing and the etch stop.

### (Example 15)

The test piece was etched by performing the same operation as in Example 14, except that the propylene of Sample 5-4 was used in place of the propylene of Sample 5-5. Table 6 shows the etching rate of the silicon nitride film and the result of confirming whether the bowing and the etch stop occurred. As shown in Table 6, it was confirmed that the etching normally progressed at an etching rate of 133 nm/min without the occurrence of the bowing and the etch stop.

### (Example 16)

The test piece was etched by performing the same operation as in Example 14, except that the propylene of Sample 5-3 was used in place of the propylene of Sample 5-5. Table 6 shows the etching rate of the silicon nitride film and the result of confirming whether the bowing and the etch stop occurred. As shown in Table 6, it was confirmed that the etching normally progressed at an etching rate of 134 nm/min without the occurrence of the bowing and the etch stop.

### (Comparative Example 11)

The test piece was etched by performing the same operation as in Example 14, except that the propylene of Sample 5-2 was used in place of the propylene of Sample 5-5. Table 6 shows the etching rate of the silicon nitride film and the result of confirming whether the bowing and the etch stop occurred. As shown in Table 6, the etching rate was 42 nm/min and the occurrence of the etch stop was confirmed.

### (Comparative Example 12)

The test piece was etched by performing the same operation as in Example 14, except that the propylene of Sample 5-1 was used in place of the propylene of Sample 5-5. Table 6 shows the etching rate of the silicon nitride film and the result of confirming whether the bowing and the etch stop occurred. As shown in Table 6, the etching rate was 39 nm/min and the occurrence of the etch stop was confirmed.

### Reference Signs List

- 1: etching compound gas supply section
- 2: dilution gas supply section
- 3: chamber
- 4: member to be etched
- 5: stage
- 6: cooling section
- 7: pressure gauge
- 8: vacuum pump

## Claims

1. An etching method comprising:
an etching step of setting a temperature of a member to be etched having an etching object containing silicon to 0°C or less, bringing an etching gas containing an etching compound into contact with the member to be etched, and etching the etching object, wherein
the etching gas contains or does not contain high-boiling-point impurities, the high-boiling-point impurities being compounds having at least one type of atom among a fluorine atom, a chlorine atom, a bromine atom, an iodine atom, a hydrogen atom, and an oxygen atom in a molecule and having a boiling point of 20°C or more under a pressure of 101 kPa, and, when the etching gas contains the high-boiling-point impurities, a total concentration of all types of the contained high-boiling-point impurities is 500 ppm by volume or less.

2. The etching method according to claim 1, wherein the total concentration of all types of the contained high-boiling-point impurities is 0.01 ppm by volume or more and 300 ppm by volume or less.

3. The etching method according to claim 1 or 2, wherein the high-boiling-point impurity is at least one type among water, hydrogen fluoride, ethanol, isopropanol, chloroform, dichloromethane, cyclohexane, benzene, iodine molecules, and bromine molecules.

4. The etching method according to any one of claims 1 to 3, wherein the etching compound is a compound having at least one type of atom among a fluorine atom, a chlorine atom, a bromine atom, an iodine atom, and a hydrogen atom in a molecule and having a boiling point of 15°C or less under a pressure of 101 kPa.

5. The etching method according to claim 4, wherein the etching compound is the compound having a fluorine atom in the molecule and is at least one type among sulfur hexafluoride, nitrogen trifluoride, chlorine trifluoride, iodine heptafluoride, phosphorus trifluoride, silicon tetrafluoride, fluorine gas, trifluoroiodomethane, carbonyl fluoride, trifluoromethyl hypofluoride, chain saturated perfluorocarbons having 1 or more and 3 or less carbon atoms, chain saturated hydrofluorocarbons having 1 or more and 3 or less carbon atoms, unsaturated perfluorocarbons having 2 or more and 5 or less carbon atoms, unsaturated hydrofluorocarbons having 2 or more and 4 or less carbon atoms, cyclic perfluorocarbons having 3 or more and 5 or less carbon atoms, and cyclic hydrofluorocarbons having 3 or more and 5 or less carbon atoms.

6. The etching method according to claim 4, wherein the etching compound is the compound having a chlorine atom in the molecule and is at least one type among boron trichloride, chlorine gas, hydrogen chloride, chlorine trifluoride, chain saturated chlorinated hydrocarbons having 1 or more and 3 or less carbon atoms, and unsaturated chlorinated hydrocarbons having 2 or 3 carbon atoms.

7. The etching method according to claim 4, wherein the etching compound is the compound having a bromine atom in the molecule and is at least one type among hydrogen bromide, chain saturated brominated hydrocarbons having 1 or more and 3 or less carbon atoms, and unsaturated brominated hydrocarbons having 2 carbon atoms.

8. The etching method according to claim 4, wherein the etching compound is the compound having an iodine atom in the molecule and is at least one type among iodine heptafluoride, hydrogen iodide, trifluoroiodomethane, and pentafluoroiodoethane.

9. The etching method according to claim 4, wherein the etching compound is the compound having a hydrogen atom in the molecule and is at least one type among chain saturated hydrocarbons having 1 or more and 4 or less carbon atoms, unsaturated hydrocarbons having 2 or more and 4 or less carbon atoms, and cyclic hydrocarbons having 3 or 4 carbon atoms.
